# FASCICULE DE BREVET EUROPEEN

(11) **EP 1 501 757 B1**
(45) Date de publication et mention de la délivrance du brevet: **16.08.2017**
(21) Numéro de dépôt: 03755160.3
(22) Date de dépôt: 07.05.2003
(51) Int. Cl.: B81C 1/00

(54) **PROCEDE POUR MODIFIER LES PROPRIETES D'UNE COUCHE MINCE ET SUBSTRAT FAISANT APPLICATION DU PROCEDE**
VERFAHREN ZUM ÄNDERN DER EIGENSCHAFTEN EINER DÜNNEN SCHICHT UND DAS VERFAHREN IMPLEMENTIERENDES SUBSTRAT
METHOD OF ALTERING THE PROPERTIES OF A THIN FILM AND SUBSTRATE IMPLEMENTING SAID METHOD

(30) Priorité: 07.05.2002 FR 0205731
(43) Date de publication de la demande: 02.02.2005
(73) Titulaire: UNIVERSITE CLAUDE BERNARD - LYON 1, 69622 Villeurbanne Cédex (FR)
(72) Inventeur: MARTY, Olivier, 69001 Lyon (FR); LYSENKO, Volodymyr, 69100 Villeurbanne (FR)
(74) Mandataire: IP Trust
(86) Numéro de dépôt international: PCT/FR2003/001423
(87) Numéro de publication internationale: WO 2003/099707

(56) Documents cités:
- FR-A- 2 689 912
- ROMANOV S I ET AL: "GESI FILMS WITH REDUCED DISLOCATION DENSITY GROWN BY MOLECULAR-BEAMEPITAXY ON COMPLIANT SUBSTRATES BASED ON POROUS SILICON" APPLIED PHYSICS LETTERS, AMERICAN INSTITUTE OF PHYSICS. NEW YORK, US, vol. 75, no. 26, 27 décembre 1999 (1999-12-27), pages 4118-4120, XP000902592 ISSN: 0003-6951 cité dans la demande
- PATENT ABSTRACTS OF JAPAN vol. 2000, no. 06, 22 septembre 2000 (2000-09-22) -& JP 2000 091627 A (MATSUSHITA ELECTRIC IND CO LTD), 31 mars 2000 (2000-03-31)
- SANCHEZ J J ET AL: "Structural and morphological characteristics of InGaAs/GaAs quantum well structures on tilted (111)B GaAs grown by MBE" JOURNAL OF CRYSTAL GROWTH, NORTH-HOLLAND PUBLISHING CO. AMSTERDAM, NL, vol. 192, no. 3-4, 1 septembre 1998 (1998-09-01), pages 363-371, XP004142190 ISSN: 0022-0248

## Description

La présente invention concerne le domaine de la réalisation de substrats comprenant au moins une couche mince déposée en surface d'un support, de tels substrats étant utilisés dans les domaines de la micro-,nano-électronique ou de la micro-,nano-technologie au sens général.

La présente invention trouve des applications particulièrement avantageuses dans le domaine des matériaux ayant des fonctions électroniques, optoélectroniques, magnétiques, supra-conductrices ou piézoélectriques par exemple.

Par exemple, certaines applications électroniques et optoélectroniques peuvent nécessiter l'utilisation de matériaux semi-conducteurs ternaires ou quaternaires. Cependant, le nombre de ces matériaux ternaires et quaternaires à haute qualité structurale qu'il est possible d'obtenir par une croissance épitaxiale est limité car il est rarement possible de trouver un substrat dont le réseau cristallin est adapté à celui de la couche semi-conductrice à faire croître. Par conséquent, l'hétéroépitaxie effectuée en désaccord de maille provoque la formation d'une quantité importante de défauts structuraux au-delà d'une épaisseur critique, ce qui entraîne irréversiblement par la suite, des modifications indésirables des propriétés physiques attendues des couches épitaxiées. Par ailleurs, l'utilisation de couches semi-conductrices simples ou composées contraintes peuvent avantageusement être utilisées pour profiter de l'amélioration de certaines propriétés. Là encore, l'utilisation d'une technique permettant de déformer ces couches de manière homogène serait avantageuse.

Pour tenter de résoudre ces problèmes, des techniques de croissance incluant la réalisation de couches tampons dont l'objectif est de permettre d'absorber les contraintes induites par la différence des paramètres de maille entre le substrat et la couche mince épitaxiée ont été développées.

Une première famille de techniques vise à utiliser des substrats compliants consistant à réaliser une épitaxie en désaccord de maille sur une fine membrane servant de couche germe. L'énergie de contrainte est alors censée être relaxée de manière élastique ou plastique par la membrane.

A titre d'exemple, une technique de compliance élastique d'une membrane germe a été décrite par S.I. Romanov et al., Appl. Phys. Lett. 75, (1999) p. 4118.

Cette technique consiste :
- à porosifier la surface d'un substrat de Si de manière à former deux couches poreuses à surface spécifiques élevées en surface, la couche de surface présentant une faible porosité alors que celle qui s'intercale entre la couche de surface et le substrat présente une porosité élevée,
- à oxyder légèrement (une monocouche maximum) la surface du substrat obtenu afin de stabiliser mécaniquement les cristallites,
- à désoxyder le substrat dans le bâti de croissance juste avant l'épitaxie d'une fine couche de Si et,
- à faire une croissance en désaccord de maille d'une couche de SiGe sur la fine couche de Si.

Le procédé décrit par Romanov et al consiste donc à réaliser une croissance épitaxiale en désaccord de maille sur une membrane de Si obtenue sur du Si poreux. Un effet de compliance (déformation) des couches poreuses semble être observé.

Des études portant sur d'autres systèmes de substrats compliants ont été menées. Il peut être cité à titre d'exemple, l'article A.M. Jones Appl. Phys. Lett. 74, (1999) p. 1000 décrivant une technique de croissance sur une membrane libre visant à déposer sur un substrat deux couches, à savoir une première qui est dite sacrificielle et ensuite la membrane fine sur laquelle est réalisée l'épitaxie. La couche sacrificielle est une couche dont la vitesse d'attaque chimique pour une solution est grande devant celle de la membrane. Une étape de lithographie est réalisée pour laisser subsister uniquement un disque de la membrane à la surface de l'échantillon qui est ensuite plongé dans la solution d'attaque chimique. La couche sacrificielle est gravée, y compris sous le disque par sous gravure. L'attaque chimique est stoppée lorsqu'il ne reste qu'un pilier pour porter le disque de la membrane sur lequel est réalisée la croissance d'une couche épitaxiée. La membrane est alors susceptible de se déformer pour limiter les déformations de la couche épitaxiée. Cette méthode présente l'avantage que la couche contrainte épitaxiée est relativement bien relaxée de manière élastique. Cependant, cette méthode présente de nombreux inconvénients comme la fragilité de la structure, la non planarité des surfaces, la difficulté du procédé de réalisation et la faible taille des zones obtenues.

Il peut être cité également une méthode dite de fusion désalignée ou « twist bonding » décrite notamment par l'article Y.H. Lo, Appl. Phys. Lett. 59, (1991) p. 2311 visant à reporter une membrane contrainte ou non, sur un substrat hôte en s'assurant de la réalisation d'une rotation entre les directions cristallographiques de la membrane et celle du substrat. Il est ainsi créé un réseau de dislocations à l'interface entre la membrane et le substrat. Il est alors réalisé une croissance d'une couche contrainte sur la membrane. Sous l'effet de l'énergie de contrainte, les dislocations sont censées changer d'orientation pour prendre un caractère coin et minimiser de cette façon cette énergie. L'avantage de cette technique porte sur le report de la membrane sur la totalité du substrat. Cependant, il n'existe aucune garantie de la relaxation ainsi réalisée et des doutes subsistent sur l'homogénéité de la relaxation obtenue.

Il peut aussi être cité à titre d'exemple la technique d'adhésion moléculaire ou « wafer bonding » décrit notamment par l'article D. M . Hansen et al., J. Cryst. Growth. 195, (1998) p. 144, visant à reporter une membrane par adhésion moléculaire sur un substrat oxydé en surface. La croissance de la couche contrainte est ensuite réalisée sur la membrane. Les atomes de la membrane présents à l'interface peuvent effectuer des petits déplacements pour relaxer la couche contrainte. L'avantage principal de cette technique est la grande taille des surfaces obtenues. Toutefois, même si un effet de compliance est observé, la relaxation n'est pas totale. Les épaisseurs critiques des couches déposées sont augmentées mais il n'est pas encore possible de réaliser des couches épaisses exemptes de défauts structuraux.

L'ensemble de ces techniques de compliance plastique ou élastique ne présentent pas les caractéristiques attendues. La déformation plastique ou élastique de la couche germe par la couche épitaxiale n'est pas ou que trop partiellement observée. D'autre part, les dimensions latérales des zones obtenues exemptes de défauts sont trop faibles.

Dans l'état de la technique, une autre famille de solutions connues concerne la technique paramorphique consistant à faire l'épitaxie d'une membrane contrainte puis de la faire relaxer élastiquement pour faire ensuite une épitaxie en accord de maille. Cette technique vise à déposer sur un substrat successivement une couche sacrificielle et une membrane contrainte par épitaxie. Une étape de lithographie permet ensuite de graver sélectivement la membrane afin d'obtenir des disques. Une gravure chimique humide est réalisée pour graver totalement la couche sacrificielle y compris sous les disques par sous gravure. La membrane contrainte se relaxe alors de manière élastique dans la mesure où elle n'est plus maintenue. Cette membrane contrainte se dépose ensuite sur le substrat. Le principal avantage de cette technique vient de la reprise de croissance en accord de maille. Cependant, les disques obtenus sont limités en taille (quelques centaines de microns) et les désaccords des paramètres initiaux de la membrane sont faibles (1% environ).

Une autre famille de solutions décrite par D.S. Cao., J. Appl. Phys. 65, (1989) p.2451 est la voie métamorphique avec l'utilisation de couches tampons de compositions fixes ou graduelles voire de super-réseaux. Les couches tampons ont un paramètre de maille différent de celui du substrat. La croissance de ces couches est réalisée pour des épaisseurs supérieures à l'épaisseur critique. La couche tampon se relaxe alors par génération de dislocations et retrouve ses paramètres de maille non contraints. La croissance de la couche active souhaitée est alors réalisée sur ces couches tampons de paramètres de maille différents de ceux du substrat d'origine. La première difficulté de cette technique provient du confinement des dislocations dans la couche tampon qui n'est pas total, des dislocations émergentes étant toujours présentes dans la couche active venant dégrader les propriétés de cette dernière. La seconde provient de l'apparition d'une rugosité à la surface de la couche tampon qui peut dégrader les propriétés attendues de la couche active.

L'état de la technique a également proposé par le document JP 2000 091 627, une technique de fabrication d'émetteurs de lumière consistant à réaliser un dépôt d'un matériau polycristallin à grains fins, suivi d'un traitement thermique. Ce recuit permet un réarrangement atomique qui conduit à l'augmentation de la taille des grains. Cependant, cette technique ne donne aucune garantie sur l'homogénéité de la réorganisation et ne permet pas d'effectuer la croissance épitaxiale d'une couche quelconque en accord de maille avec son substrat.

L'analyse des différentes techniques connues à ce jour conduit à constater qu'elles ne donnent pas satisfaction en pratique. Il apparaît donc le besoin de pouvoir disposer d'une technique permettant soit d'effectuer la croissance épitaxiale d'une couche quelconque en accord de maille avec son substrat soit de déformer la couche mince souhaitée afin qu'elle possède des propriétés différentes de la même couche mince non déformée.

La déposante a exprimé le besoin de pouvoir disposer d'une technique permettant de modifier les paramètres de maille d'un substrat afin de permettre soit l'épitaxie en accord de maille de matériaux cristallins, soit l'utilisation directe du substrat déformé pour ses propriétés modifiées. Pour satisfaire ce besoin, la déposante propose une technique permettant de modifier le paramètre de maille d'une couche mince contrainte ou non, réalisée directement ou indirectement sur un support formant ensemble un substrat. D'une manière plus générale, cette technique permet non seulement de modifier le paramètre de maille mais diverses autres propriétés d'une couche mince déposée en surface d'un support formant un substrat pouvant être utilisé dans le domaine de la micro-,nano-électronique ou de la micro-,nano-technologie.

L'objet de l'invention concerne un procédé pour modifier les propriétés d'une couche mince. Le procédé selon l'invention est conforme à la revendication 1.

Selon une variante préférée de réalisation, le procédé consiste à traiter le support nanostructuré à surface spécifique élevée par voie chimique pour assurer une déformation correspondant à une dilatation ou à une contraction de sa nanostructure.

Selon une caractéristique de l'invention, le procédé consiste à choisir un support nanostructuré à surface spécifique élevée parmi diverses nanostructures à base de métaux, de semi-conducteurs ou de matériaux diélectriques.

Selon une variante préférée de réalisation, le procédé consiste après le traitement du support nanostructuré à surface spécifique élevée, à effectuer sur la couche mince, la croissance épitaxiale d'un matériau cristallin.

De préférence, le procédé consiste à choisir une couche mince apte à posséder après traitement du support nanostructuré à surface spécifique élevée, un paramètre de maille correspondant au paramètre de maille du matériau cristallin destiné à être formé par croissance épitaxiale sur ladite couche mince.

De préférence, le procédé consiste à réaliser sur le support nanostructuré à surface spécifique élevée, une couche mince précontrainte ou non.

Selon une variante de réalisation, le procédé consiste à former sur le support nanostructuré à surface spécifique élevée, au moins une couche intermédiaire entre la couche mince et le support nanostructuré à surface spécifique élevée.

Avantageusement, le procédé consiste à effectuer sur la couche mince, la croissance épitaxiale d'un matériau cristallin choisi parmi les matériaux semi-conducteurs, magnétiques ou supra-conducteurs.

Avantageusement encore, le procédé consiste à réaliser sur le support nanostructuré à surface spécifique élevée une couche mince réalisée en un matériau possédant des propriétés piézoélectriques.

Selon une variante de réalisation, le procédé consiste à réaliser sur la couche mince une opération de lithographie pour faire apparaître des zones piézoélectriques.

Selon une autre variante de réalisation, le procédé consiste à déformer le support nanostructuré à surface spécifique élevée de manière qu'apparaisse des charges électriques au niveau de la couche mince.

Un autre objet de l'invention vise à proposer un substrat pour la micro-,nano-électronique ou la micro-, nano-technologie selon la revendication 12, formé par un support nanostructuré à surface spécifique élevée et déformé à la suite d'un traitement et sur la surface duquel est réalisé au moins une couche mince déformée en correspondance du support.

Avantageusement, le substrat comporte une couche épitaxiale d'un matériau cristallin semi-conducteur, magnétique ou supra-conducteur, formée sur la couche mince.

Avantageusement, le substrat comporte une couche mince réalisée en un matériau piézoélectrique.

Un autre objet de l'invention vise l'application du substrat à la réalisation d'un élément optoélectronique.

Un autre objet de l'invention vise l'application du substrat à la réalisation d'un composant électronique.

Diverses autres caractéristiques ressortent de la description faite ci-dessous en référence aux dessins annexés qui montrent, à titre d'exemples non limitatifs, des formes de réalisation de l'objet de l'invention.

La **fig. 1** illustre un substrat sur lequel est appliqué le procédé conforme à l'invention.

Les **fig. 2a à 2d** illustrent les différentes phases d'un premier exemple de réalisation d'un substrat comprenant une couche mince adaptée à la croissance épitaxiale.

Les **fig. 3, 3a, 4a, 5a** illustrent les différentes phases d'une première variante de réalisation d'un substrat mettant en oeuvre le procédé conforme à l'invention.

Les **fig. 3b et 4b** illustrent les différentes phases d'une deuxième variante de réalisation d'un substrat mettant en oeuvre le procédé conforme à l'invention.

Les **fig. 6a, 6b, 6c** illustrent les différentes phases caractéristiques du procédé conforme à l'invention mis en oeuvre pour un matériau piézoélectrique.

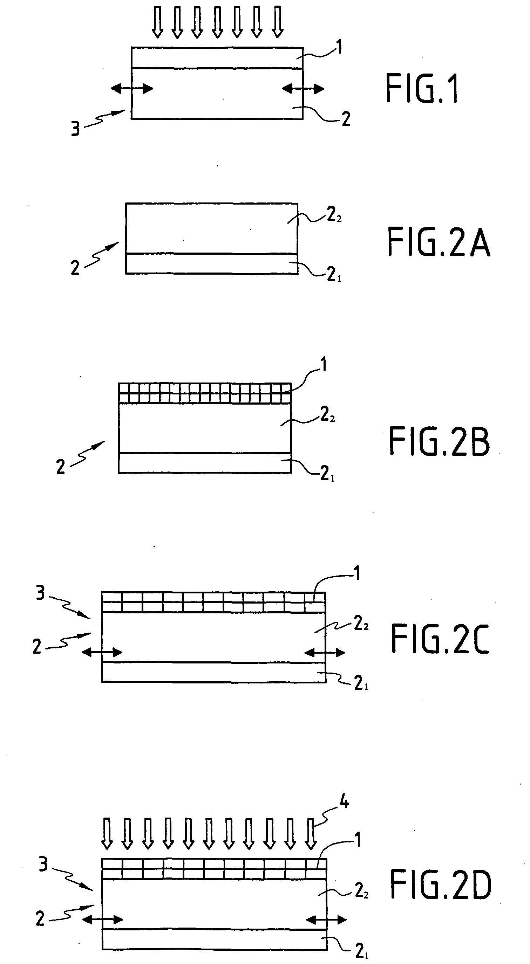

Tel que cela ressort de la **fig. 1**, l'objet de l'invention concerne un procédé pour modifier les propriétés d'une couche mince **1** réalisée à la surface planaire d'un support **2** formant ensemble, un substrat **3** destiné à être utilisé dans les domaines de la micro-,nano-électronique ou de la micro-,nano-technologie.

Le procédé selon l'invention consiste à prendre un support nanostructuré **2** présentant une surface spécifique élevée, c'est-à-dire un support qui contient au moins une couche constituée de nanocristallites et/ou de nanoparticules de diverses formes géométriques interconnectées entre elles et dont au moins une dimension est inférieure ou égale à 1 000 nm et dont la somme des surfaces de chaque nanoristallite et/ou nanoparticule soit plus grande que la surface planaire occupée par ladite couche. Divers matériaux nanostructurés peuvent être utilisés pour constituer le support nanostructuré **2** selon l'invention à savoir par exemple :
- les nanostructures à surface spécifique élevée à base de métaux ou semi-métaux,
- les semi-conducteurs nanostructurés à surface spécifique élevée tels que par exemple le silicium poreux ou d'autres semi-conducteurs nanostructurés de type IV, IV-IV, III-V, II-VI, etc.,
- ou les matériaux diélectriques nanostructurés à surface spécifique élevée à base de TᵢO₂ (anatase, rutile), Al₂O₃, ZnO, etc.

Le procédé selon l'invention vise à former ou à réaliser sur la surface planaire du support nanostructuré **2** au moins une couche mince **1** dite de contrainte. Cette couche mince de contrainte **1** est soit rapportée directement ou indirectement sur le support nanostructuré **2** à l'aide par exemple d'un collage utilisant des moyens d'adhésion moléculaire, soit déposée par une méthode quelconque, soit réalisée à partir du support nanostructuré **2.**

La couche mince se trouve réalisée en un matériau dépendant de l'application envisagée pour le substrat **3** tel que, par exemple, un métal, un diélectrique, un semi-conducteur ou un polymère de tous types.

Le procédé selon l'invention vise ensuite à traiter le support nanostructuré **2** pour générer des contraintes internes dans le support entraînant sa déformation au moins dans le plan de la couche mince **1** afin d'en modifier ses propriétés. Le support nanostructuré **2** est traité de manière à changer son volume, c'est-à-dire à le dilater ou à le contracter de manière que la couche mince **1** subisse à l'interface entre le support nanostructuré **2** et la couche mince **1**, la même déformation que le support nanostructuré **2.** La couche mince **1** se retrouve alors en tension ou en compression.

Il doit être compris que les contraintes internes engendrées dans le support nanostructuré **2** par le traitement se relaxent ensuite, partiellement ou complètement, par la déformation des nanocristallites et/ou nanoparticules à l'échelle nanométrique entraînant la déformation macroscopique du support nanostructuré **2.**

Les moyens utilisables pour générer ces contraintes internes sont multiples et peuvent être utilisés soit séparément soit conjointement. L'un de ces moyens consiste à modifier la physico-chimie des nanocristallites et/ou nanoparticules. A titre d'exemple, une modification de la chimie des nanocristallites entraîne des variations des distances interatomiques moyennes des atomes formant les nanocristallites. Ces modifications de nature chimique se traduisent par des contraintes internes apparaissant à l'échelle nanométrique qui se relaxent par une déformation des nanocristallites tout en entraînant une déformation macroscopique du support nanostructuré. Un autre moyen consiste à combler le vide présent entre les nanocristallites par insertion de matière (par exemple lors d'un dépôt en phase vapeur). Cet ajout de matière comprime les nanocristallites qui se déforment. L'un des avantages de cette technique est de permettre de modifier le coefficient de dilatation thermique global du support en choisissant la nature des dépôts réalisés entre les nanocristallites de manière à faire correspondre ce coefficient à celui de la couche épitaxiée. L'opération de traitement du support nanostructuré **2** qui vise à assurer sa déformation est réalisée par tout moyen approprié tel que chimique par exemple.

Le procédé selon l'invention permet donc de faire varier le volume du support nanostructuré **2**, par un effet de dilatation ou de contraction, afin d'assurer la déformation correspondante, à savoir une dilatation ou une contraction de la couche mince **1** à l'interface avec le support. Un tel procédé permet de modifier les propriétés de la couche mince **1**, telles que physiques ou morphologiques (variation du paramètre de maille, épaisseur, ...), électriques (levée de la dégénérescence de la bande de valence dans les semi-conducteurs, apparition de charges pour les couches piézoélectriques, changement de constante diélectrique, modification des propriétés de transport électrique comme par exemple, la variation de la mobilité des électrons et des trous dans du silicium, ...), magnétiques (modification du cycle d'Hystérésis avec la modification de la symétrie cristalline pour les matériaux ferromagnétiques) ou optiques (modification de l'énergie d'absorption des photons, d'indice de réfraction, ...).

Le procédé selon l'invention permet d'obtenir un substrat **3** ne présentant pas de limite de taille, tout en étant compatible avec les nano ou micro-technologies de fabrication collective de composants. Cette solution présente également l'avantage d'un coût réduit de réalisation.

Les **fig. 2a à 2d** illustrent une première variante de réalisation d'un substrat **3** obtenu par le procédé selon l'invention et destiné à permettre la croissance d'une couche épitaxiale en accord de maille parfait ou quasi-parfait.

La **fig. 2a** illustre un support **2** nanostructuré partiellement par un procédé permettant la porosification nanométrique de sa structure cristalline ou par un procédé permettant la croissance d'une couche nanostructurée sur sa surface. Le support **2** nanostructuré partiellement comporte une couche non nanostructurée **2₁** et une couche nanostructurée **2₂.** Bien entendu, la couche **2₁** peut être constituée d'une série de couches de nature chimique différentes. Cette couche **2₁** peut être de nature chimique différente ou non de la couche **2₂.** Cette couche **2₁** peut être contrainte par rapport à la couche **2₂** avant l'opération de déformation. De même, il est à noter que l'objet de l'invention peut être mis en oeuvre avec un support **2** nanostructuré complètement.

Dans l'exemple illustré, le support nanostructuré **2** comprend une couche **2₁** de silicium monocristallin et une couche **2₂** de silicium poreux nanostructuré. Tel que cela ressort plus précisément de la **fig. 2b**, une couche mince **1** est réalisée sur le support à savoir sur la couche de silicium poreux nanostructuré **2₂.** Cette couche mince **1** est par exemple constituée par du phosphure d'indium (InP) et se trouve réalisée par épitaxie par jets moléculaires ou autres.

Tel que cela ressort plus précisément de la **fig. 2c**, le support **2** est soumis à un traitement par exemple chimique tel que oxydation, hydrogénation ou autre permettant de modifier fortement l'état de contrainte dans le support nanostructuré **2**, ce qui provoque la dilatation ou la contraction de sa nanostructure. Cette dilatation ou contraction du support nanostructuré **2** entraîne une dilatation ou contraction correspondante de la couche mince **1** à l'interface avec le support nanostructuré **2.** La contraction ou la dilatation du support nanostructuré **2** permet respectivement de diminuer ou d'augmenter le paramètre de maille de la couche mince **1** dans le plan de l'interface.

Le procédé selon l'invention consiste ensuite à procéder à une épitaxie **4** par exemple en parfait accord de maille sur la surface libre de la couche mince déformée **1.** Par exemple, il peut être procédé à une épitaxie d'une couche de InGaAs sur une couche mince de InP déformée.

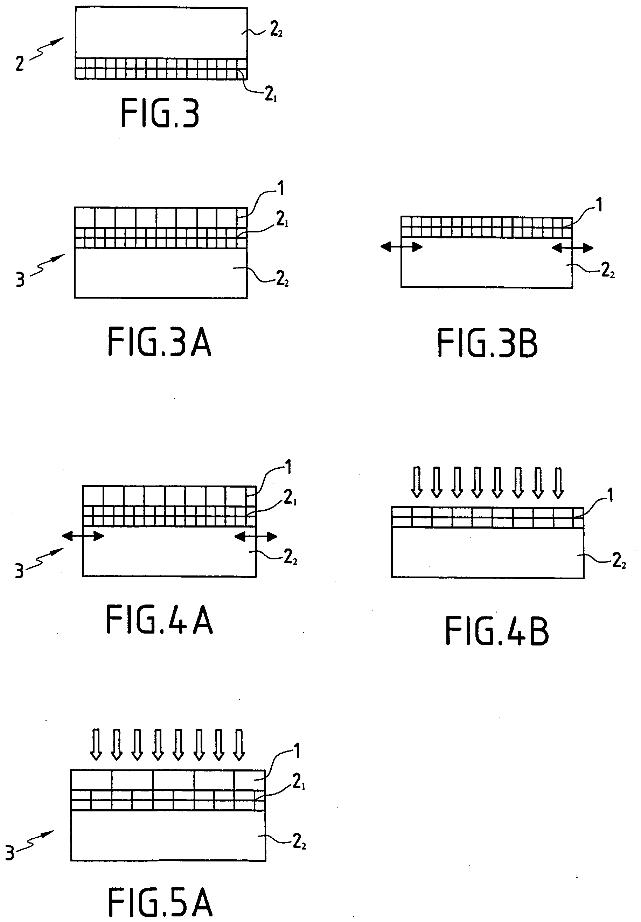

Les **fig. 3, 3b** et **4b** illustrent un autre exemple de réalisation d'un substrat mettant en oeuvre le procédé selon l'invention et visant à éliminer l'étape d'assemblage du support nanostructuré avec la couche mince. Tel que cela apparaît plus précisément à la **fig. 3**, le support **2** est nanostructuré partiellement par un procédé permettant la porosification nanométrique d'une partie de sa structure cristalline ou par un procédé permettant la croissance d'une couche nanostructurée. Le support **2** comporte une couche **2₁** non nanostructurée et une couche **2₂** nanostructurée. Cette couche **2₁** peut être contrainte par rapport à la couche **2₂** avant l'opération de déformation. De plus, les couches **2₁** et **2₂** peuvent être de nature chimique différente ou non. Par exemple, le support **2** comporte une couche **2₁** de silicium-germanium (SiₓGe₁₋ₓ) monocristallin et une couche **2₂** de silicium nanostructuré. La couche **2₁** de SiₓGe₁₋ₓ monocristallin est contrôlée en épaisseur afin de constituer la couche mince **1.** Tel que cela ressort plus précisément de la **fig. 3b**, un tel support nanostructuré est traité pour assurer sa déformation, de manière à assurer une déformation correspondante de la couche mince **1** de SiₓGe₁₋ₓ monocristallin. Comme expliqué ci-dessus, cette opération de déformation permet de faire varier le paramètre de maille de la couche mince **1** de SiₓGe₁₋ₓ monocristallin dans le plan de l'interface autorisant comme illustré à la **fig. 4b**, une opération d'épitaxie **4** d'un matériau cristallin tel que GaAs en accord de maille.

Les **fig. 3a** à **5a** illustrent une autre variante de réalisation de mise en oeuvre du procédé selon l'invention à partir d'un support nanostructuré **2** décrit à la **fig. 3** visant également à réaliser la couche mince **1** par-dessus au moins une couche intermédiaire en silicium monocristallin **2₁** du support nanostructuré **2**. Les critères de choix de l'épaisseur de cette couche intermédiaire **2₁** sont les mêmes que pour la couche mince **1**. Sur cette couche intermédiaire **2₁** de silicium monocristallin, il est prévu de former une couche mince **1**, par exemple en phosphure d'indium. Conformément à la **fig. 4a**, un tel support **2** est traité pour assurer sa déformation permettant de modifier le paramètre de maille de la couche mince **1** de phosphure d'indium. Bien entendu, le paramètre de maille de la couche **2₁** de silicium monocristallin a également changé. Comme cela apparaît plus précisément à la **fig. 5a****,** il peut être procédé à une épitaxie **4** d'un matériau cristallin tel qu'une couche InGaAs sur la couche mince **1** de phosphore d'indium. Cette variante peut être utilisée si la réalisation de la couche mince **1** est plus facile à réaliser sur la couche de silicium monocristallin **2₁** que sur la couche de silicium poreux nanostructuré **2₂.** De manière générale, il est évident que dans le cas où le support nanostructuré **2** est partiellement nanostructuré, la couche **2₂** représente la partie nanostructurée du support et la couche **2₁**, la partie non nanostructurée.

Tel que cela ressort de la description qui précède, la couche mince **1** est choisie de manière à posséder, après traitement du support nanostructuré **2,** un paramètre de maille correspondant au paramètre de maille du matériau cristallin destiné à être formé par croissance épitaxiale sur ladite couche mince **1**. Il est à noter que la couche mince **1** peut être formée ou réalisée sur le substrat nanostructuré **2** sous une forme précontrainte ou non. De plus, la couche mince **1** est formée ou réalisée sur un support **2** non encore ou déjà nanostructuré.

La couche mince **1** présente une épaisseur qui est déterminée en fonction de deux critères :
- la couche mince **1** doit être d'épaisseur suffisamment faible devant le support nanostructuré **2** pour éviter, après la déformation, une courbure trop importante du substrat (support nanostructuré et couche mince),
- la couche mince doit être d'épaisseur suffisamment faible pour que la déformation n'engendre pas de défauts structuraux et reste donc de nature élastique.

D'une manière générale, la nature de la couche mince sera choisie par rapport aux propriétés physiques modifiées attendues après déformation. Dans le cas particulier d'une hétéroépitaxie, le matériau constituant la couche mince **1** sera choisi en fonction du matériau qui doit être épitaxié par-dessus de façon que leurs paramètres de maille soit le plus proche possible l'un de l'autre. Par exemple, sur la couche mince **1**, il peut être effectué le dépôt de polymères ou la croissance épitaxiale d'un matériau cristallin choisi parmi les matériaux :
- Semi-conducteurs tels que :
   - Famille IV-IV : Si, Ge, SiₓGe₁₋ₓ, SiC, SiₓGe_{y}C_{1-x-y}
   - Famille III-V : GaₓAl₁₋ₓAs, GaₓIn₁₋ₓAs, AlₓIn₁₋ₓAs, GaₓIn₁₋ₓAs_{y}P_{1-y}, GaₓAl₁₋ₓP, GaₓAl₁₋ₓN, GaₓIn₁₋ₓN,GaₓIn₁₋ₓSb, GaₓAl₁₋ₓSb, (GaₓIn₁₋ₓ)_{1-y}Tl_{y}As, (GaₓIn₁₋ₓ)_{1-y}Tl_{y}P,
   - Famille II-VI : ZnₓCd₁₋ₓTe_{y}Se_{1-y}, CdₓHg₁₋ₓTe
- Supra conducteurs tels que YbaCuO,
- Magnétiques tels que :
   - matériaux ferromagnétiques : Fer, Cobalt, Nickel ainsi que leurs alliages et quelques terres rares,
   - matériaux paramagnétiques.

Tel que cela ressort de la description qui précède, l'objet de l'invention concerne un procédé permettant de modifier les propriétés d'une couche mince **1** préalablement réalisée sur un support nanostructuré **2** en le déformant pour entraîner une déformation correspondante de la couche mince.

Ce procédé permet d'obtenir un substrat comprenant un support nanostructuré **2** déformé à la suite d'un traitement et sur la surface duquel est réalisé au moins une couche mince **1** déformée en correspondance du support. Un tel substrat est destiné à comporter une couche mince d'un matériau quelconque formant la couche mince **1**. Une application de ce substrat est la réalisation de composants électroniques susceptibles de profiter des propriétés modifiées apportées par la déformation de la couche mince **1**. Une autre application possible d'un tel substrat est de constituer un élément optoélectronique en utilisant la possibilité de modifier les propriétés optiques de la couche mince obtenues par la déformation de sa structure.

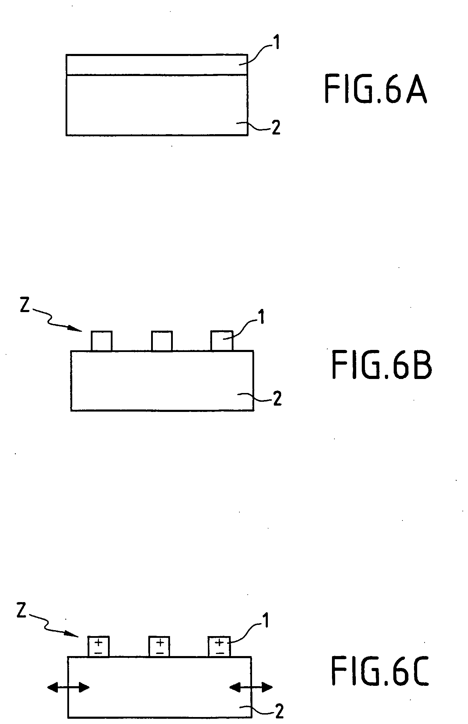

Les **fig. 6a** à **6c** illustrent un autre exemple d'application du procédé selon l'invention permettant d'utiliser les propriétés piézoélectriques d'une couche mince.

Selon cet exemple d'application, le procédé consiste à réaliser sur un support nanostructuré **2** au moins une couche mince **1** réalisée en un matériau possédant des propriétés piézoélectriques. Il est ensuite réalisé sur cette couche mince **1**, une opération de lithographie pour faire laisser subsister des zones piézoélectriques **z** tel que cela apparaît plus précisément à la **fig. 6b**. Il est à noter qu'il peut être réalisé différents types d'opérations de lithographie tels que optique, électronique ou aux rayons X.

Le traitement d'un tel support nanostructuré **2** pour assurer sa déformation tel que décrit précédemment conduit à une déformation correspondante de la couche mince **1** permettant de faire apparaître des charges électriques au niveau de la couche mince et notamment au niveau des zones piézoélectriques **3** tel que cela apparaît clairement à la **fig. 6c**. Il est à noter que l'opération de lithographie peut être réalisée après l'opération de traitement du support nanostructuré poreux **2** entraînant sa déformation.

Le procédé selon l'invention permet aussi d'obtenir un substrat pour la micro-,nano-technologie. Ainsi, dans le cas où la couche mince **1** formée sur le support nanostructuré est réalisée en un matériau piézoélectrique, il peut être obtenu des éléments de forme contrôlée utilisant des propriétés piézoélectriques.

L'invention n'est pas limitée aux exemples décrits et représentés car diverses modifications peuvent y être apportées sans sortir de son cadre défini par les revendications.

## Revendications

1. Procédé pour modifier les propriétés d'une couche mince (1) réalisée en surface d'un support (2) formant un substrat (3) utilisé dans le domaine de la micro-,nano-électronique ou de la micro-,nano-technologie, **caractérisé en ce qu'**il consiste:
- à réaliser sur un support nanostructuré à surface spécifique élevée (2), au moins une couche mince (1),
- et à traiter ensuite le support nanostructure à surface spécifique élevée (2) pourvu de la couche mince (1) de manière à générer des contraintes internes dans le support entraînant sa déformation par dilatation ou contraction au moins dans le plan de la couche mince de manière à assurer une déformation correspondante de la couche mince pour en modifier ses propriétés.

2. Procédé selon la revendication 1, **caractérisé en ce qu'**il consiste à traiter le support nanostructure à surface spécifique élevée (2) par voie chimique pour assurer une déformation correspondant à une dilatation ou à une contraction de sa nanostructure.

3. Procédé selon la revendication 1, **caractérisé en ce qu'**il consiste à choisir un support nanostructuré à surface spécifique élevée (2) parmi diverses nanostructures à base de métaux, de semi-conducteurs ou de matériaux diélectriques.

4. Procédé selon la revendication 1 ou 2, **caractérisé en ce qu'**il consiste après le traitement du support nanostructuré à surface spécifique élevée (2), à effectuer sur la couche mince (1), la croissance épitaxie d'un matériau cristallin.

5. Procédé selon la revendication 4, **caractérisé en ce qu'**il consiste à choisir une couche mince (1) apte à posséder après traitement du support nanostructuré à surface spécifique élevée (2), un paramètre de maille correspondant au paramètre de maille du matériau cristallin destiné à être formé par croissance épitaxiale sur ladite couche mince (1).

6. Procédé selon la revendication 5, **caractérisé en ce qu'**il consiste à réaliser sur le support nanostructuré à surface spécifique élevée (2), une couche mince (1) précontrainte ou non.

7. Procédé selon la revendication 1, **caractérisé en ce qu'**il consiste à former sur le support nanostructuré à surface spécifique élevée (2), au moins une couche intermédiaire (2) entre la couche mince (1) et le support nanostructure à surface spécifique élevée (2).

8. Procédé selon les revendications 4, 5 et 7, **caractérisé en ce qu'**il consiste à effectuer sur la couche mince (1), la croissance épitaxiale d'un matériau cristallin choisi parmi les matériaux semi-conducteurs, magnétiques ou supra-conducteurs.

9. Procédé selon l'une des revendications 1 à 3, **caractérisé en ce qu'**il consiste à réaliser sur le support nanostructuré à surface spécifique élevée (2) une couche mince (1) réalisée en un matériau possédant des propriétés piézoélectriques.

10. Procédé selon la revendication 9, **caractérisé en ce qu'**il consiste à réaliser sur la couche mince (1) une opération de lithographie pour faire apparaître des zones piézoélectriques (z).

11. Procédé selon la revendication 9 ou 10, **caractérisé en ce qu'**il consiste à déformer le support nanostructuré à surface spécifique élevée (2) de manière qu'apparaisse des charges électriques au niveau de la couche mince.

12. Substrat pour la micro-,nano-électronique ou pour la micro-,nano-technologie, **caractérisé en ce qu'**il est formé par un support nanostructuré à surface spécifique élevée (2) et déformé par dilatation ou contraction à la suite d'un traitement appliqué au support et sur la surface duquel est réalisé au moins une couche mince (1) déformée en correspondance du support avec un paramètre de maille en tension ou compression.

13. Substrat selon la revendication 12, **caractérisé en ce qu'**il comporte une couche épitaxiale (4) d'un matériau cristallin semi-conducteur, magnétique ou supra-conducteur, formée sur la couche mince (1).

14. Substrat selon la revendication 12, **caractérisé en ce que** la couche mince (1) est réalisée en un matériau piézoélectrique.

15. Application du substrat selon la revendication 12 à la réalisation d'un élément optoélectronique.

16. Application du substrat selon la revendication 12 à la réalisation d'un composant électronique.

## Patentansprüche

1. Verfahren zur Veränderung der Eigenschaften einer Dünnschicht (1) an der Oberfläche eines Trägers (2) in Form eines Substrats (3), das im Bereich der Mikro-,Nanoelektronik oder der Mikro-,Nanotechnolgie verwendet wird, **dadurch gekennzeichnet, dass** das Verfahren darin besteht:
- auf einem nanostrukturierten Träger mit erhöhter spezifischer Oberfläche (2) mindestens eine Dünnschicht (1) zu bilden,
- und den Nanostrukturträger mit erhöhter spezifischer Oberfläche (2), der mit der Dünnschicht (1) versehen ist, anschließend so zu behandeln, dass im Träger innere Spannungen erzeugt werden, die zumindest im Bereich der Dünnschicht zu deren Verformung durch Expansion oder Kontraktion führen, so dass eine entsprechende Verformung der Dünnschicht zur Veränderung ihrer Eigenschaften gewährleistet ist.

2. Verfahren nach Anspruch 1, **dadurch gekennzeichnet, dass** das Verfahren darin besteht, den Nanostrukturträger mit erhöhter spezifischer Oberfläche (2) chemisch zu behandeln, um eine Verformung zu gewährleisten, die einer Expansion oder einer Kontraktion seiner Nanostruktur entspricht.

3. Verfahren nach Anspruch 1, **dadurch gekennzeichnet, dass** das Verfahren darin besteht, aus verschiedenen Nanostrukturen auf Basis von Metallen, Halbleitern oder dielektrischen Materialien einen nanostrukturierten Träger mit erhöhter spezifischer Oberfläche (2) zu wählen.

4. Verfahren nach Anspruch 1 oder 2, **dadurch gekennzeichnet, dass** das Verfahren darin besteht, nach Behandlung des nanostrukturierten Trägers mit erhöhter spezifischer Oberfläche (2) auf der Dünnschicht (1) ein epitaxiales Wachstum eines kristallinen Materials zu bewirken.

5. Verfahren nach Anspruch 4, **dadurch gekennzeichnet, dass** das Verfahren darin besteht, eine Dünnschicht (1) zu wählen, die dazu befähigt ist, nach Behandlung des nanostrukturierten Trägers mit erhöhter spezifischer Oberfläche (2) eine Gitterkonstante zu besitzen, die der Gitterkonstante des kristallinen Materials entspricht, welches durch epitaxiales Wachstum auf der Dünnschicht (1) gebildet werden soll.

6. Verfahren nach Anspruch 5, **dadurch gekennzeichnet, dass** das Verfahren darin besteht, auf dem nanostrukturierten Träger mit erhöhter spezifischer Oberfläche (2) eine Dünnschicht (1) mit oder ohne Vorspannung zu bilden.

7. Verfahren nach Anspruch 1, **dadurch gekennzeichnet, dass** das Verfahren darin besteht, auf dem nanostrukturierten Träger mit erhöhter spezifischer Oberfläche (2) zwischen der Dünnschicht (1) und dem Nanostrukturträger mit erhöhter spezifischer Oberfläche (2) mindestens eine Zwischenschicht (2) zu bilden.

8. Verfahren nach den Ansprüchen 4, 5 und 7, **dadurch gekennzeichnet, dass** das Verfahren darin besteht, auf der Dünnschicht (1) ein epitaxiales Wachstum eines kristallinen Materials zu bewirken, welches aus Halbleiter-, Supraleiter- oder magnetischen Materialen gewählt wurde.

9. Verfahren nach einem der Ansprüche 1 bis 3, **dadurch gekennzeichnet, dass** das Verfahren darin besteht, auf dem nanostrukturierten Träger mit erhöhter spezifischer Oberfläche (2) eine Dünnschicht (1) aus einem Material zu bilden, das piezoelektrische Eigenschaften besitzt.

10. Verfahren nach Anspruch 9, **dadurch gekennzeichnet, dass** das Verfahren darin besteht, auf der Dünnschicht (1) eine lithografische Bearbeitung durchzuführen, um die piezoelektrischen Bereiche (z) hervortreten zu lassen.

11. Verfahren nach Anspruch 9 oder 10, **dadurch gekennzeichnet, dass** das Verfahren darin besteht, den nanostrukturierten Träger mit erhöhter spezifischer Oberfläche (2) derart zu verformen, dass im Bereich der Dünnschicht elektrische Ladungen entstehen.

12. Substrat für die Mikro-, Nanoelektronik oder für die Mikro-, Nanaotechnologie, **dadurch gekennzeichnet, dass** das Substrat durch einen nanostrukturierten Träger mit erhöhter spezifischer Oberfläche (2) gebildet und im Anschluss an eine Behandlung, die am Träger und an der Oberfläche, aus dem mindestens eine Dünnschicht (1) gebildet ist, durch Expansion oder Kontraktion verformt wird, wobei die Dünnschicht je nach Träger mit einer Zug- oder Druck-Gitterkonstante verformt wird.

13. Substrat nach Anspruch 12, **dadurch gekennzeichnet, dass** das Substrat eine epitaxiale Schicht (4) aus einem kristallinen Halbleiter-, Supraleiter- oder magnetischen Material besitzt, die auf der Dünnschicht (1) ausgebildet ist.

14. Substrat nach Anspruch 12, **dadurch gekennzeichnet, dass** die Dünnschicht (1) aus einem piezoelektrischen Material besteht.

15. Aufbringung des Substrats nach Anspruch 12 bei Herstellung eines optoelektronischen Elements.

16. Aufbringung des Substrats nach Anspruch 12 bei Herstellung eines elektronischen Bauteils.

## Claims

1. A method for modifying the properties of a thin layer (1) made on a surface of a support (2) forming a substrate (3) used in the field of micro-/nanoelectronics or micro-/nanotechnology, **characterized in that** it consists:
- in making at least one thin layer (1) on a nanostructured support (2) having a high specific surface area,
- and then treating the nanostructured support (2) having a high specific surface area provided with the thin layer (1) so as to generate internal stresses in the support causing its deformation by expansion or contraction at least in the plane of the thin layer so as to ensure a corresponding deformation of the thin layer to modify its properties.

2. The method according to claim 1, **characterized in that** it consists in treating the nanostructured support (2) having a high specific surface chemically to ensure a deformation corresponding to an expansion or contraction of its nanostructure.

3. The method according to claim 1, **characterized in that** it consists in choosing a nanostructured support (2) having high specific surface among various nanostructures based of metals, semiconductors or dielectric materials.

4. The method according to claim 1 or 2, **characterized in that** it consists, after treatment of the nanostructured support (2) having a high specific surface in carrying out on the thin layer (1) the epitaxial growth of a crystalline material.

5. The method according to claim 4, **characterized in that** it consists in choosing a thin layer (1) adapted to have, after treatment of the nanostructured support (2) having a high specific surface, a lattice parameter corresponding to the lattice parameter of the crystalline material to be formed by epitaxial growth on said thin layer (1).

6. The method according to claim 5, **characterized in that** it consists in making a thin layer (1) on the nanostructured support (2) having a high specific surface, prestressed or not.

7. The method according to claim 1, **characterized in that** it consists in forming on the nanostructured support (2) having a high specific surface at least one intermediate layer (2) between the thin layer (1) and the nanostructured support (2) having high specific surface.

8. The method according to claims 4, 5, and 7, **characterized in that** it consists in making on the thin layer (1) the epitaxial growth of a crystalline material selected among semiconductor, magnetic, or superconducting materials.

9. The method according to any one of claims 1 to 3, **characterized in that** it consists in making on the nanostructured support (2) having a high specific surface a thin layer (1) made of a material having piezoelectric properties.

10. The method according to claim 9, **characterized in that** it consists in making on the thin layer (1) a lithography operation in order to reveal piezoelectric areas (z).

11. The method according to claim 9 or 10, **characterized in that** it consists in deforming the nanostructured support (2) having a high specific surface so that electrical charges appear at the thin layer.

12. A substrate for micro-/nano-electronics or for micro-/nanotechnology, **characterized in that** it is formed by a nanostructured support (2) having a high specific surface and deformed by expansion or contraction as a result of a treatment applied to the support and on the surface of which is made at least one thin layer (1) deformed in correspondence to the support with a lattice parameter in tension or compression.

13. The substrate according to claim 12, **characterized in that** it comprises an epitaxial layer (4) of a semiconductor, magnetic, or superconducting crystalline material formed on the thin layer (1).

14. The substrate according to claim 12, **characterized in that** the thin layer (1) is made of a piezoelectric material.

15. An application of the substrate according to claim 12 to the making of an optoelectronic element.

16. The application of the substrate according to claim 12 to the making of an electronic component.
